# EUROPEAN PATENT SPECIFICATION

(11) **EP 0 569 856 B1**
(45) Date of publication and mention of the grant of the patent: **06.08.1997**
(21) Application number: 93107374.6
(22) Date of filing: 06.05.1993
(51) Int. Cl.: H03M 1/34

(54) **A/D Converter**
A/D-Wandler
Convertisseur analogique-numérique

(30) Priority: 11.05.1992 JP 144783/92
(43) Date of publication of application: 18.11.1993
(73) Proprietor: YOZAN INC., Tokyo 155 (JP); SHARP KABUSHIKI KAISHA, Osaka 545 (JP)
(72) Inventor: Yamamoto, Makoto, Setagaya-ku, Tokyo 155 (JP)
(74) Representative: Grünecker, Kinkeldey, Stockmair & Schwanhäusser Anwaltssozietät

(56) References cited:
- EP-A- 0 119 509
- EP-A- 0 316 223

## Description

### FIELD OF THE INVENTION

The present invention relates to an A/D converter for converting analog signal into digital signal with predetermined descrete levels.

### BACKGROUND OF THE INVENTION

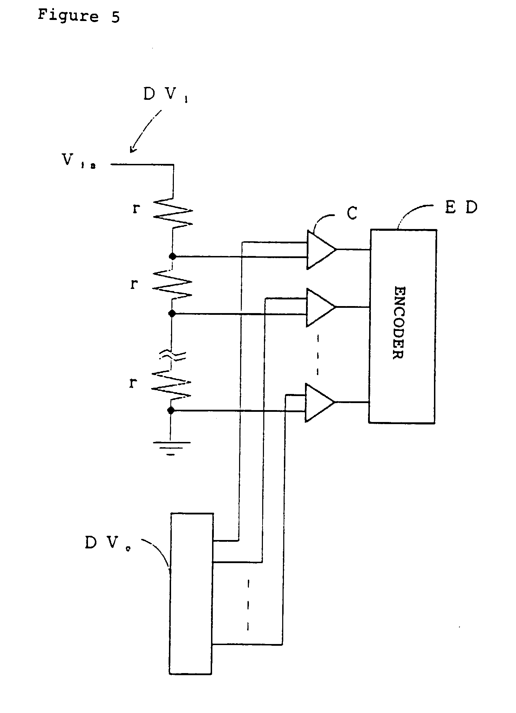

As in Figure 5, conventionally and generally, an A/D converter distributes input voltage Vin by voltage divider DV1, compares the distributed voltage with the offset voltage by comparator C, and converts the result of comparison into digital signal with the predetermined width by encoder ED. The offset voltage is generated by reference voltage generating means, such as DV0.

In this way the conventional A/D converter has a rather large circuit and consumes electric power.

EP-A-0 119 509 discloses an A/D converter in which reference voltages are connected to comparators via adding means. Such a converter reduces the number of necessary components.

EP-A-0 316 223 discloses an A/D converter which uses single-gate FETs in conjunction with a cascaded structure in order to be able to function at a very high frequency.

### SUMMARY OF THE INVENTION

The present invention solves the above problems and has an object to provide an A/D converter realized by a small size circuit.

An A/D converter according to the present invention uses FET comprising plural gates as inverse logic. Inverting each output, digital value can be obtained.

### BRIEF DESCRIPTION OF THE DRAWINGS

Figure 1 shows a circuit of an embodiment of the A/D converter according to the present invention.

Figure 2 shows a graph of the characteristic of inverting step circuit in the embodiment.

Figure 3 shows a graph of the digital output in the embodiment.

Figure 4 shows a concept of a FET in the embodiment.

Figure 5 shows a circuit of a conventional A/D converter.

### PREFERRED EMBODIMENT OF THE PRESENT INVENTION

Hereinafter an embodiment according to the present invention is described with reference to the attached drawings.

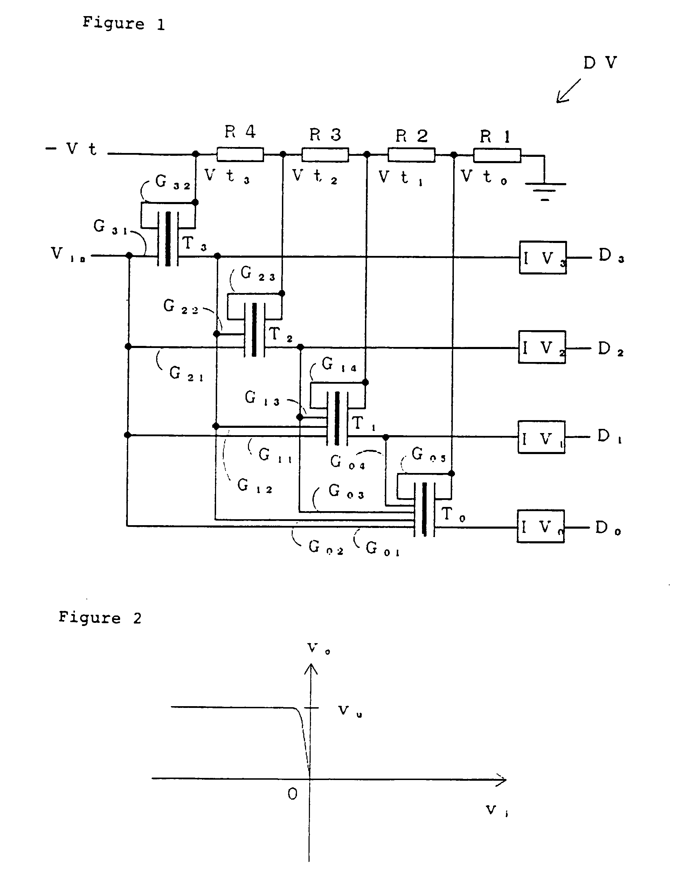

Figure 1 shows an A/D converter for converting input voltage Vin into digital value of 4 bits. The A/D converter consists of FETs from T0 to T3 each of which has a plural number of gates. These FETs correspond the each digit place of the digital value: T0, T1, T2 and T3 correspond LSB, the second digit, the third digit and MSB, respectively.

The input voltage Vin is input to G01, G11, G21 and G31 which are one of the gates of FETs. The output of each FET is inverted in inverting step circuit from IV0 to IV3 and the output on each digit place of D0 to D3 are generated.

The output of FET on upper digit place is input to the gate of FET T0 to T3, simultaneously, offset voltage Vt0 to Vt3 generated in voltage divider DV are input. The offset voltage determines the upper limit of digit place corresponding each FET. Each FET outputs the inverted value on the digit place according to the input voltage Vin, the output of the upper FET and the offset voltage. FET has the characteristic of addition with respect to the gate voltage and becomes conductive when the summation of the gate voltage is equal to or more than the predetermined value (it is 0V in the description below), and then the impressive voltage of drain is generated in the source.

The output of each FET is input to inverting step circuits from IV0 to IV3, and the output of each digit place can be obtained according to the characteristic in Figure 2. In an inverting step circuit, the output "v0" is 0 for any plus input "vi" and the voltage "vu" is generated for a minus input corresponding to digital "1". The offset voltage from Vt0 to Vt3 are settled as below.${\text{Vt0=-vu×2}}^{\text{0}}$${\text{Vt1=-vu×2}}^{\text{1}}$${\text{Vt2=-vu×2}}^{\text{2}}$${\text{Vt3=-vu×2}}^{\text{3}}$

The action of FET is described giving an example FET "T0" of LSB in Figure 4.

FET "T0" comprises five gates G01, G02, G03, G04 and G05. Offset voltage Vt0 is impressed on drain D. As shown below, each gate receives the input.
Gate G01: Input voltage Vin
Gate G02: Output of FET T3
Gate G03: Output of FET T2
Gate G04: Output of FET T1
Gate G05: Offset voltage Vt0

Representing the voltage to be impressed to gates from G01 to G05 by V1 to V5, respectively, and step function by S( ), a function can be obtained as below. 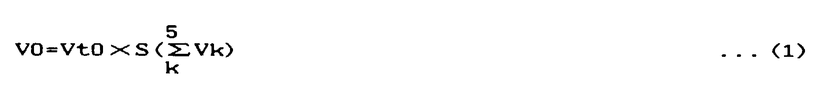 The formula in (1) can be varied as below.$\text{V0=Vt0×S(Vt0+V2+V3+V4+Vin)}$$\text{=Vt0×S{Vt0+(an output of FET T3)+(an output of} \text{FET T2)+(an output of FET T1)+Vin}}$

For example when Vin is 10×vu, FET T3 is conductive and Vt3 (=8×vu) is input to the gate of FET T2. Then, (Vin+Vt2+Vt3), which is equal to (10-4-8)vu, which is equal to -2vu is input to the gate of FET T2: but FET T2 does not become conductive because the input is not plus value. The gate voltage below is impressed to FET T1 and T0.$\text{T1: (Vin+Vt1+Vt3)=(10-2-8)vu=0V}$$\text{T0: (Vin+Vt1+Vt0+Vt3)=(10-2-1-8)vu=-vu}$

T1 and T3 become conductive and T0 and T2 does not become conductive. Only IV1 and IV3 receive minus voltage which is converted into "1" by inverting step function. As the result, D0 and D2 are 0 and D1 and D3 are 1. That means a digital output "1010" is generated.

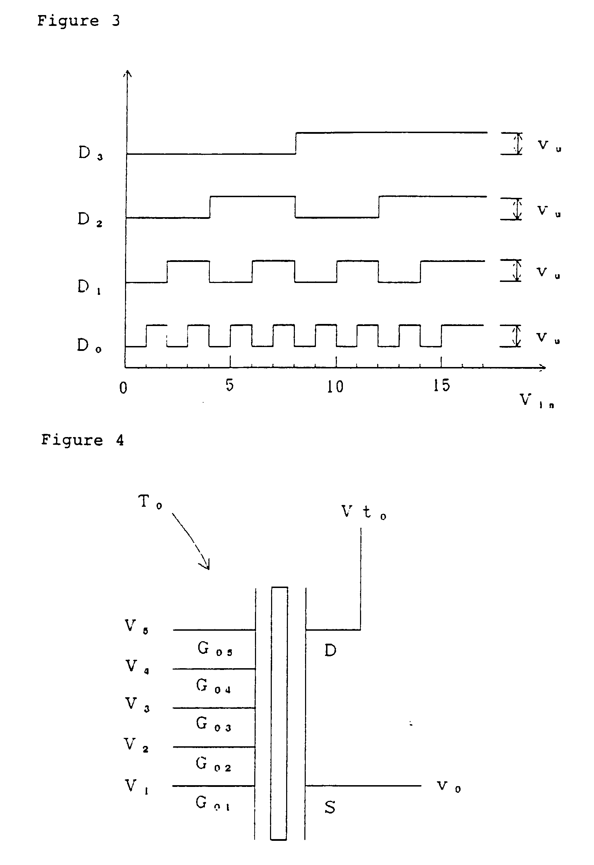

The change from D0 to D3 corresponding to the change of input Vin is shown in Figure 3.

A digital value of 1 bit can be generated by one (1) FET and one (1) inverting step circuit. The size of it is much smaller than the conventional circuit which needs a comparator, an encoder and a resistance. It is easy to realize it by LSI.

As mentioned, it is possible to realize an A/D converter by a small circuit because the A/D converter according to the present invention uses a FET comprising plural gates as the inverted logic of each digit place of digital value, and obtains a digital value by inverting the each output.

## Claims

1. An A/D converter for generating a discrete output voltage with a plurality of levels (D₀-D₃) in response to an input analog voltage (Vᵢₙ), comprising:
i) a plurality of FETs (T₀-T₃) each of which corresponding to one of said levels of said output voltage (D₀-D₃), each said FET having a plurality of gates (G₀₁ to G₃₂) for receiving:
outputs of FETs on higher levels,
said input voltage (Vᵢₙ) and
an offset voltage (Vₜ₀-Vₜ₃) of negative value;
and each of said FETs receiving the respective offset voltage as a drain voltage;
ii) a voltage divider (DV) for generating said offset voltages (Vₜ₀-Vₜ₃) for each said FET;
iii) a plurality of inverters (IV₀-IV₃) corresponding to each said FET for outputting a constant positive voltage in response to a negative output of said corresponding FET and for outputting a zero voltage in response to a positive output voltage of said corresponding FET.

## Patentansprüche

1. A/D-Wandler zum Erzeugen einer diskreten Ausgangsspannung mit einer Vielzahl von Pegeln (D₀-D₃) in Anwort auf eine analoge Eingangsspannung (Vᵢₙ), mit:
i) einer Vielzahl von FETs (T₀-T₃), von denen jeder mit einem der Pegel der Ausgangsspannung D₀-D₃) korrespondiert, wobei jeder FET eine Vielzahl von Gatebereichen (G₀₁-G₃₂) aufweist, um folgende Signale zu empfangen:
die Ausgangssignale von FETs von höheren Pegeln,
die Eingangsspannung (Vᵢₙ), und
eine Offset-Spannung (Vₜ₀-Vₜ₃) mit negativem Wert;
und wobei jeder FET die entsprechende Offset-Spannung als Drain-Spannung empfängt;
ii) einem Spannungsteiler (DV) zum Erzeugen der Offset-Spannungen (Vₜ₀-Vₜ₃) für jeden FET;
iii) einer Vielzahl von Invertierern (IV₀-IV₃) entsprechend jedem der FETs zum Ausgeben einer konstanten positiven Spannung in Antwort auf ein negatives Ausgangssignal des entsprechenden FETs und zum Ausgeben einer Null-Spannung in Antwort auf eine positive Ausgangsspannung des entsprechenden FETs.

## Revendications

1. Convertisseur analogique-numérique pour produire une tension de sortie discrète avec plusieurs niveaux (D₀-D₃) en réponse à une tension analogique d'entrée (Vᵢₙ), comprenant :
i) plusieurs transistors à effet de champ (FET) (T₀-T₃) correspondant chacun à l'un desdits niveaux de ladite tension de sortie (D₀-D₃), chacun desdits FET ayant plusieurs grilles (G₀₁ à G₃₂) pour recevoir :
des sorties de FET sur des niveaux supérieurs,
ladite tension d'entrée (Vᵢₙ) et
une tension de décalage (Vₜ₀-Vₜ₃) de valeur négative ;
et chacun desdits FET recevant la tension de décalage respective sous la forme d'une tension de drain ;
ii) un diviseur de tension (DV) pour produire lesdites tensions de décalage (Vₜ₀-Vₜ₃) pour chacun desdits FET ;
iii) plusieurs circuits inverseurs (IV₀-IV₃) correspondant à chacun desdits FET pour sortir une tension positive constante en réponse à une sortie négative dudit FET correspondant et pour sortir une tension de zéro en réponse à une tension de sortie positive dudit FET correspondant.
